# EUROPEAN PATENT APPLICATION

(11) **EP 4 787 427 A1**
(43) Date of publication of application: **05.08.2026**
(21) Application number: 24871923.9
(22) Date of filing: 13.09.2024
(51) Int. Cl.: H01L 21/304, B24B 37/00, C09G 1/02, C09K 3/14

(54) **POLISHING COMPOSITION AND POLISHING METHOD**

(30) Priority: 25.09.2023 JP 2023161703
(71) Applicant: Fujimi Incorporated, Kiyosu-shi, Aichi 452-8502 (JP)
(72) Inventor: MOMOTA, Satoshi, Kiyosu-shi, Aichi 452-8502 (JP); ICHITSUBO, Taiki, Kiyosu-shi, Aichi 452-8502 (JP); ITO, Shohei, Kiyosu-shi, Aichi 452-8502 (JP); TANAKA, Yuki, Kiyosu-shi, Aichi 452-8502 (JP)
(74) Representative: Grünecker Patent- und Rechtsanwälte PartG mbB
(86) International application number: PCT/JP2024/032909
(87) International publication number: WO 2025/070128

(57) **Abstract**

Provided is a polishing composition that is used in polishing a silicon material surface and capable of providing good wettability to the polished surface with reduced defects. The polishing composition contains an abrasive (A), a basic compound (B), a first water-soluble polymer (C1), and a second water-soluble polymer (C2) that has a different chemical structure from the first water-soluble polymer (C 1). The first water-soluble polymer (C 1) is a random copolymer having a vinyl alcohol unit and an N-vinylpyrrolidone unit.

## Description

### [Technical Field]

The present invention relates to a polishing composition.

This application claims priority to Japanese Patent Application No. 2023-161703, filed on September 25, 2023; and the entire content thereof is herein incorporated by reference.

### [Background Art]

Precision polishing is performed on the surfaces of materials such as metals, semimetals, nonmetals and their oxides, using polishing compositions. For example, the surface of a silicon wafer used as a component of a semiconductor device is generally finished to a high-quality mirror surface through a lapping step (rough polishing step) and a polishing step (precision polishing step). The polishing step typically includes a stock polishing step and a final polishing step. Patent Documents 1 and 2 are exemplary technical references of a polishing composition mainly used for polishing semiconductor substrates such as silicon wafers.

### [Citation List]

### [Patent Literature]

[Patent Document 1] Japanese Patent No. 6185432
[Patent Document 2] Japanese Patent Application Publication No. 2020-161603

### [Summary of Invention]

### [Technical Problem]

Polishing compositions used for polishing semiconductor substrates such as silicon wafers (e.g., polishing compositions used in the final polishing step, especially the final polishing step of semiconductor substrates such as silicon wafers and other substrates) are required to have the ability to achieve a surface with low haze and few surface defects after polishing. For instance, when substrates are properly protected by a water-soluble polymer in the polishing composition, it is possible to improve surface quality after polishing, such as haze value reduction. For instance, Patent Documents 1 to 2 describe a polishing composition that includes colloidal silica and ammonia as well as polyacryloylmorpholine and polyvinyl alcohol as water-soluble polymers, and discuss haze value reduction by the polishing composition. On the other hand, in case of insufficient substrate protection by the water-soluble polymers, defects occur on the polished surface, which are detected as, for example, light point defects (LPD). If residues of the water-soluble polymers are present on the polished substrate surface, they will be detected as particles during substrate surface inspection, which can also increase LPD. For these reasons, when polishing with a water-soluble-polymer-containing polishing composition, the degree of reduction of defects (such as LPD) on the polished substrate surface is checked to evaluate whether or not it has high surface quality.

To obtain a high-quality surface, it is preferable that the polished silicon wafer surface has sufficient wettability. By keeping the polished surface wet with water (with water film), it is possible to prevent direct deposition of foreign matter on the polished surface. A silicon wafer with such a surface is more likely to have a high-quality surface after cleaning.

The present invention has been created in view of these circumstances with an objective to provide a polishing composition for use in polishing a surface formed of a silicon material and capable of providing good wettability to the polished surface with reduced defects.

### [Solution to Problem]

The present description provides a polishing composition used in polishing a surface formed of a silicon material (or a silicon material surface). The polishing composition includes an abrasive (A), a basic compound (B), a first water-soluble polymer (C1), and a second water-soluble polymer (C2) that has a different chemical structure from the first water-soluble polymer (C1). The first water-soluble polymer (C1) is a random copolymer having a vinyl alcohol unit and an N-vinylpyrrolidone unit. According to the polishing composition, the polished silicon material surface has good wettability with reduced surface defects.

In some embodiments, the second water-soluble polymer (C2) is at least one kind selected from the group consisting of a cellulose derivative, a starch derivative, an oxyalkylene-unit-containing polymer, a polyvinyl alcohol-based polymer, a nitrogen-atom-containing (N-containing) polymer and a carboxylic acid-based polymer. The combined use of the first water-soluble polymer (C1) and the second water-soluble polymer (C2) selected from the above kinds preferably brings about good wettability and defect reduction.

In some embodiments, the weight ratio of the second water-soluble polymer (C2) content to the first water-soluble polymer (C1) content is 0.1 or higher and 20 or lower. In an embodiment using the first water-soluble polymer (C1) and the second water-soluble polymer (C2) at such a ratio, the effect of the art disclosed herein can be preferably obtained.

In some embodiments, the first water-soluble polymer (C1) has a weight-average molecular weight (Mw) of 2×10⁴ or lower. The use of the first water-soluble polymer (C1) with such Mw preferably brings about good wettability and defect reduction.

In some embodiments, the polishing composition includes silica particles as the abrasive (A). The polishing composition including silica particles as the abrasive helps obtain a polished surface with good surface quality.

In some embodiments, the polishing composition further includes a surfactant (D). With such a composition, good surface quality tends to result after polishing.

The polishing composition disclosed herein may be a concentrated liquid. The polishing composition disclosed herein may be produced, distributed, and stored in a concentrated liquid form.

In some embodiments, a polishing method is provided, the method including a step of polishing a surface formed of a silicon material, using the polishing composition. According to the polishing method, the polished silicon material surface can have good wettability with reduced surface defects.

### [Description of Embodiments]

Preferred embodiments of the present invention will be described below. Matters other than those particularly mentioned herein but are necessary for implementation of the present invention can be understood as design matters for those skilled in the art based on related technologies in the pertaining field. The present invention can be implemented based on the contents disclosed herein and common technical knowledge in the field.

### <Abrasive (A)>

The polishing composition disclosed herein includes an abrasive. The abrasive contributes to an increase in polishing removal rate by mechanically polishing the surface of an object to be polished. The abrasive is not particularly limited in material, properties, etc., and can be appropriately selected according to the purpose and the way of using the polishing composition. Examples of the abrasive include inorganic particles, organic particles, and organic-inorganic composite particles. Specific examples of inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; and carbonates such as calcium carbonate and barium carbonate. Specific examples of organic particles include polymethylmethacrylate (PMMA) particles, poly(meth)acrylic acid particles (in which (meth)acrylic acid comprehensively refers to acrylic acid and methacrylic acid), and polyacrylonitrile particles. These abrasives can be used singly or in combination of two or more kinds.

As the abrasive, inorganic particles (in particular, particles formed of a metal or semimetal oxide) are preferable, and silica particles are especially preferable. In the polishing composition that can be used in polishing (e.g., final polishing) of objects having a silicon surface, such as silicon wafers, it is particularly beneficial to employ silica particles as the abrasive. For instance, the art disclosed herein can be preferably implemented in an embodiment using essentially only silica particles as the abrasive. From such a viewpoint, the amount of silica particles in the total amount of abrasive is suitably 90 % by weight (wt%) or greater, preferably 95 wt% or greater, more preferably 98 wt% or greater (e.g., 99 wt% to 100 wt%).

Specific examples of the silica particles include colloidal silica, fumed silica, and precipitated silica. The silica particles can be used singly or in combination of two or more kinds thereof. Colloidal silica is particularly preferable because it helps obtain a polished surface with a good surface grade after polishing. Examples of the colloidal silica include colloidal silica prepared by ion exchange starting from water glass (sodium silicate) and alkoxide colloidal silica (colloidal silica produced by the hydrolysis and condensation reaction of alkoxysilane). As the colloidal silica, solely one kind or a combination of two or more kinds can be used.

The silica particles are preferably formed of a silica having an absolute specific gravity of 1.5 or greater, more preferably 1.6 or greater, even more preferably 1.7 or greater. The maximum absolute specific gravity of the silica is not particularly limited. It is typically 2.3 or less, for instance, 2.2 or less. The absolute specific gravity of the silica particles can be a measurement value determined by a liquid substitution method using ethanol as the substitution liquid.

The average primary particle diameter of the abrasive (typically, silica particles, suitably colloidal silica) is not particularly limited. In view of the polishing removal rate, etc., it is preferably 5 nm or greater, more preferably 10 nm or greater. In view of obtaining good polishing results (e.g., haze reduction, defect removal, etc.), the average primary particle diameter is preferably 15 nm or greater, or more preferably 20 nm or greater (e.g., greater than 20 nm). In view of low scratches and the like, the average primary particle diameter of the abrasive is preferably 100 nm or less, more preferably 50 nm or less, even more preferably 45 nm or less. In view of helping to obtain a surface with lower haze, in some embodiments, the average primary particle diameter of the abrasive is preferably 43 nm or less, or may be less than 40 nm, less than 38 nm, less than 35 nm, less than 32 nm, or less than 30 nm.

As used herein, the average primary particle diameter refers to the particle size (BET particle size) calculated from the specific surface area (BET value) determined by the BET method according to the formula: average primary particle diameter (nm) = 6000/(true density (g/cm³) × BET value (m²/g)). The specific surface area can be measured using, for instance, a surface area analyzer, product name FLOWSORB II 2300 available from Micromeritics Instrument Corporation.

The average secondary particle diameter of the abrasive (typically, silica particles) is not particularly limited. For instance, it can be appropriately selected in the range of about 15 nm to 300 nm. In view of increasing the polishing removal rate, the average secondary particle diameter is preferably 30 nm or greater, or more preferably 35 nm or greater. In some embodiments, the average secondary particle diameter may be, for instance, 40 nm or greater, 42 nm or greater, or preferably 44 nm or greater. In typical, the average secondary particle diameter may be 250 nm or less, preferably 200 nm or less, or more preferably 150 nm or less. In some preferred embodiments, the average secondary particle diameter is 120 nm or less, more preferably 100 nm or less, or even more preferably 70 nm or less, or may be, for instance, 60 nm or less, or 50 nm or less.

As used herein, the average secondary particle diameter refers to the particle diameter (volume average particle diameter) determined by dynamic light scattering. For instance, the average secondary particle diameter of the abrasive can be determined by dynamic light scattering, using product name NANOTRAC UPA-UT151 available from Nikkiso Co., Ltd.

The shape (outer shape) of the abrasive (typically, silica particles) may be globular or non-globular. Specific examples of non-globular particles include peanut-shaped (i.e., peanut shell-shaped), cocoon-shaped, conpeito-shaped and rugby ball-shaped particles. For instance, it is preferable to use silica particles that are mostly peanut-shaped or cocoon-shaped.

While no particular limitations are imposed, the average length/width ratio (average aspect ratio) of the abrasive (typically, silica particles) is theoretically 1.0 or higher, preferably 1.05 or higher, more preferably 1.1 or higher, or may be 1.2 or higher. With increasing average aspect ratio, a higher polishing removal rate can be obtained. In view of reducing scratches, etc., the average aspect ratio of the abrasive (typically, silica particles) is preferably 3.0 or lower, more preferably 2.0 or lower, even more preferably 1.5 or lower, or may be 1.4 or lower.

The shape (outer shape) and average aspect ratio of the abrasive (typically, silica particles) can be obtained, for instance, by electron microscopy. For instance, in a particular procedure for determining the average aspect ratio, a scanning electron microscope (SEM) is used to draw the smallest rectangle circumscribing each particle image for a prescribed number (e.g., 200) of abrasive grains (polisher particles, typically silica particles) whose individual particle shapes can be recognized. Then, for the rectangle drawn for each particle image, the long side length (long diameter value) is divided by the short side length (short diameter value) to determine the length/width ratio (aspect ratio). The average aspect ratio can be obtained by taking the arithmetic average of the aspect ratios of the prescribed number of particles.

### <Basic Compound (B)>

The polishing composition disclosed herein includes a basic compound. As used herein, the term basic compound refers to a compound that dissolves in water and increases the pH of the aqueous solution. With the basic compound in the polishing composition, by its chemical polishing action (alkali etching), the object to be polished can be efficiently polished. Possible basic compounds include nitrogen-containing (N-containing) organic or inorganic basic compounds, phosphorous-containing (P-containing) basic compounds, hydroxides of alkali metals, hydroxides of alkaline earth metals, and various carbonates or hydrogen carbonates. Examples of the N-containing basic compounds include quaternary ammonium compounds, ammonia and amines (preferably, water-soluble amines). Examples of the P-containing basic compounds include quaternary phosphonium compounds. These basic compounds can be used singly or in combination of two or more kinds thereof.

Specific examples of the hydroxides of alkali metals include potassium hydroxide and sodium hydroxide. Specific examples of the carbonate salts and hydrogen carbonate salts include ammonium hydrogen carbonate, ammonium carbonate, potassium hydrogen carbonate, potassium carbonate, sodium hydrogen carbonate, and sodium carbonate. Specific examples of the amines include, methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, piperazine anhydride, piperazine hexahydrate, 1-(2-aminoethyl) piperazine, N-methylpiperazine, guanidine, and azoles such as imidazole and triazole. Specific examples of the quaternary phosphonium compounds include quaternary phosphonium hydroxides such as tetramethylphosphonium hydroxide and tetraethylphosphonium hydroxide.

As the quaternary ammonium compound, quaternary ammonium salts (typically, strong bases) such as tetraalkyl ammonium salts and hydroxyalkyl trialkyl ammonium salts can be used. Examples of the anion in such a quaternary ammonium salt include OH⁻, F⁻, Cl⁻, Br , I⁻, ClO₄⁻, and BH₄⁻. Examples of the quaternary ammonium compound include quaternary ammonium salts having OH⁻ as the anion, namely, quaternary ammonium hydroxides. Specific examples of the quaternary ammonium hydroxides include tetraalkyl ammonium hydroxides such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; and hydroxyalkyl trialkylammonium hydroxides such as 2-hydroxyethyltrimethylammonium hydroxide (or choline).

Among these basic compounds, at least one kind of basic compound selected from hydroxides of alkali metal, quaternized ammonium hydroxide, or ammonia can be preferably used, for example. In particular, more preferred are tetraalkyl ammonium hydroxide (e.g., tetramethyl ammonium hydroxide) and ammonia, and particularly preferred is ammonia.

### <Water-Soluble Polymers (C)>

The polishing composition disclosed herein includes at least two kinds of water-soluble polymers. In other words, the polishing composition disclosed herein includes a first water-soluble polymer (C1) and a second water-soluble polymer (C2). In particular, by using a combination of the first water-soluble polymer (C1) and the second water-soluble polymer (C2) described below, on the grounds of different effects of the respective water-soluble polymers, the polished surface has good wettability with reduced surface defects.

### <First Water-Soluble Polymer (C1)>

The first water-soluble polymer is a random copolymer that includes a vinyl alcohol unit (or "VA unit" hereinafter) and an N-vinylpyrrolidone unit (or "VP unit" hereinafter). Here, in one molecule of the random copolymer, the VA unit is a structural unit (repeating unit) represented by the next chemical formula -CH₂-CH(OH)-. The VA unit can be obtained, for instance, by hydrolysis (saponification) of a structural unit formed by vinyl polymerization of a vinyl ester monomer such as vinyl acetate. In one molecule of the random copolymer, the VP unit is a structural unit derived from N-vinylpyrrolidone as a monomer. The first water-soluble polymer can be obtained, for instance, by partial or complete saponification of a copolymer of vinyl acetate and N-vinylpyrrolidone. With the use of the first water-soluble polymer having such a chemical structure, while favorably protecting the surface being polished, the polished surface can have good wettability. As the first water-soluble polymer, it is possible to use solely one kind or a combination of two or more kinds varying in molar ratio of VA units and VP units or varying in Mw.

The VA unit to VP unit molar ratio (VA/VP) in the first water-soluble polymer is not particularly limited. The molar ratio (VA/VP) can be set in a suitable range in which the random copolymer is effective. In some embodiments, the molar ratio (VA/VP) can be, for instance, 50/50 or higher, 65/35 or higher, 70/30 or higher, 75/25 or higher, 80/20 or higher, 85/15 or higher, or 90/10 or higher (e.g., above 90/10). In some embodiments, the molar ratio (VA/VP) can be, for instance, 99/1 or lower, 98/2 or lower, 97/3 or lower, 95/5 or lower, or 93/7 or lower.

The weight-average molecular weight (Mw) of the first water-soluble polymer is not particularly limited. Whether having a low or high molecular weight, a random copolymer having a VA unit and a VP unit can provide sufficient wettability. While no particular limitations are imposed, in some embodiments, the first water-soluble polymer may have a Mw of, for instance, 100×10⁴ or lower, or suitably 60×10⁴ or lower. In view of concentration efficiency, etc., in some preferable embodiments, the Mw is 30×10⁴ or lower, or may be, for instance, 20×10⁴ or lower, 10×10⁴ or lower, 8×10⁴ or lower, 5×10⁴ or lower, or 3×10⁴ or lower. The lower the Mw is, the higher the dispersion stability of the first water-soluble polymer tends to be. The Mw is preferably 2×10⁴ or lower, or may be, for instance, 1.8×10⁴ or lower, or 1.5×10⁴ or lower (e.g., below 1.5×10⁴). The use of the first water-soluble polymer with Mw in these ranges can preferably bring about good wettability and defect reduction. In view of enhancing the wettability after polishing while favorably protecting the surface being polished, in some embodiments, the Mw can be, for instance, 0.2×10⁴ or higher, 0.25×10⁴ or higher, 0.3×10⁴ or higher, 0.5×10⁴ or higher, or 0.8×10⁴ or higher. As the Mw of the first water-soluble polymer increases, the effect to enhance the protection of the object to be polished tends to increase. From such a viewpoint, in some preferable embodiments, the Mw is 1.0×10⁴ or higher (e.g., above 1.0×10⁴), or may be 1.5×10⁴ or higher, 1.8×10⁴ or higher, 2.0×10⁴ or higher (e.g., above 2.0×10⁴), 2.3×10⁴ or higher, 2.5×10⁴ or higher, or 2.8×10⁴ or higher.

The Mw of a water-soluble polymer can be calculated from a value based on aqueous-phase gel permeation chromatography (GPC) (aqueous phase, based on standard polyethylene oxides). The same applies to the Mw values of the first and second water-soluble polymers. As the GPC system, model name HLC-8320 GPC available from Tosoh Corporation can be used. The analysis conditions can be as follows. The same method is also employed in the working examples described later.

### [GPC Analysis Conditions]

Sample concentration: 0.1 wt%
Column: TSKgel GMPW_{XL}
Detector: differential refractometer
Eluent: 100 mM aqueous NaNO₃ solution
Flow rate: 1 mL/min
Measurement temperature: 40 °C
Injection volume: 200 µL

While no particular limitations are imposed, in some embodiments, the amount of the first water-soluble polymer in the polishing composition can be, for instance, 0.01 part by weight or greater per 100 parts by weight of abrasive (typically silica particles). In view of improving the wettability, etc., it is suitably 0.1 part by weight or greater, preferably 0.5 part by weight or greater, more preferably 1 part by weight or greater, or may be 1.5 parts by weight or greater, or 2 parts by weight or greater. The amount of the first water-soluble polymer per 100 parts by weight of abrasive can be, for instance, 50 parts by weight or less, or 30 parts by weight or less. In view of dispersion stability of the polishing composition, etc., in some embodiments, the amount of the first water-soluble polymer per 100 parts by weight of abrasive is suitably 15 parts by weight or less, preferably 10 parts by weight or less, and more preferably 5 parts by weight or less, and may be 3 parts by weight or less, or 2.5 parts by weight or less. By using the first water-soluble polymer in an amount suitably set within these ranges, while protecting the surface being polished, the polished surface can have good wettability.

### <Second Water-Soluble Polymer (C2)>

The polishing composition disclosed herein includes a second water-soluble polymer in addition to the first water-soluble polymer. The second water-soluble polymer has a different chemical structure different from the first water-soluble polymer. As the second water-soluble polymer, it is preferable to use one, two or more kinds selected from water-soluble polymers other than random copolymers having VA and VP units. By using the first and second water-soluble polymers in combination, the surface being polished can be favorably protected and defects can be reduced.

The second water-soluble polymer can be a compound having a hydroxyl group, a carboxy group, an acyloxy group, a sulfo group, an amide structure, an imido structure, a quaternary ammonium structure, a heterocyclic structure, a vinyl structure or the like in the molecule. Examples of the second water-soluble polymer include cellulose derivatives, starch derivatives, oxyalkylene unit-containing polymers, polyvinyl alcohol-based polymers, nitrogen atom-containing polymers, and carboxylic acid-based polymers. The second water-soluble polymer may be derived from natural products or synthetic.

In some embodiments, a polymer derived from a natural product is used as the second water-soluble polymer. Examples of the naturally-derived polymer include cellulose derivatives and starch derivatives.

In some preferable embodiments, a cellulose derivative is used as the second water-soluble polymer. Here, the cellulose derivative is a polymer that includes a β-glucose unit as the main repeating unit. Specific examples of the cellulose derivative include hydroxyethyl cellulose (HEC), hydroxypropyl cellulose, hydroxyethylmethyl cellulose, hydroxypropylmethyl cellulose, methylcellulose, ethylcellulose, ethylhydroxyethyl cellulose, and carboxy methylcellulose. HEC is particularly preferable.

In some embodiments, a starch derivative is used as the second water-soluble polymer. The starch derivative includes an α-glucose unit as a main repeating unit. Examples include pregelatinized starch, pullulan, carboxymethyl starch, and cyclodextrin.

In some preferable embodiments, a synthetic polymer is used as the second water-soluble polymer. The effect to improve surface quality disclosed herein is preferably obtained in an embodiment using a synthetic polymer as the second water-soluble polymer.

In some embodiments, an oxyalkylene unit-containing polymer is used as the second water-soluble polymer. Examples of the oxyalkylene unit-containing polymer include polyethylene oxide (PEO), a block copolymer of ethylene oxide (EO) and propylene oxide (PO) or butylene oxide (BO), and a random copolymer of EO and PO or BO. Among them, block and random copolymers of EO and PO are preferable. The block copolymer of EO and PO may be a diblock or triblock copolymer having a PEO block and a polypropylene oxide (PPO) block. Examples of the triblock copolymer include PEO-PPO-PEO triblock copolymers and PPO-PEO-PPO triblock copolymers. PEO-PPO-PEO triblock copolymers are typically preferable.

As used herein, the term copolymer comprehensively refers to various copolymers such as random copolymer, alternate copolymer, block copolymer, and graft copolymer, unless otherwise stated.

In a block or random copolymer of EO and PO, the molar ratio (EO/PO) of EO and PO forming the copolymer is preferably higher than 1, more preferably 2 or higher, and even more preferably 3 or higher (e.g., 5 or higher) in view of water solubility, cleanability, etc.

In some embodiments, the second water-soluble polymer may include a polyvinyl alcohol-based polymer. The polyvinyl alcohol-based polymer used as the second water-soluble polymer refers to a polymer having a VA unit as a repeating unit, but excludes a random copolymer having VA and VP units. The polyvinyl alcohol-based polymer may have only the VA unit as the repeating unit or may have a different repeating unit (or a non-VA unit) other than the VA unit in addition to the VA unit. The polyvinyl alcohol-based polymer may be a random, block, alternate or graft copolymer that has a VA unit and a non-VA unit. The polyvinyl alcohol-based polymer may have only one kind of non-VA unit, or two or more kinds of non-VA units.

The polyvinyl alcohol-based polymer may be an unmodified polyvinyl alcohol (unmodified PVA) or a modified polyvinyl alcohol (modified PVA). As used herein, the term unmodified PVA refers to a polyvinyl alcohol-based polymer that is formed by hydrolysis (saponification) of polyvinyl acetate and is essentially free of non-VA units and a repeating unit having the structure (-CH₂-CH(OCOCH₃)-) resulting from vinyl polymerization of vinyl acetate. The unmodified PVA may have a degree of saponification of, for instance, 60 % or higher. In view of water solubility, it can be 70 % or higher, 80 % or higher, or 90 % or higher. In some embodiments, the unmodified PVA may have a degree pf saponification of 98 % or higher (completely saponified).

The polyvinyl alcohol-based polymer may be a modified PVA having a VA unit, and a non-VA unit having at least one structure selected from an oxyalkylene group, a carboxy group, a (di)carboxylic group, a (di)carboxylic ester group, a phenyl group, a naphthyl group, a sulfo group, an amino group, a hydroxy group, an amide group, an imide group, a nitrile group, an ether group, an ester group, or salts thereof. Examples of the non-VA unit that may be contained in the modified PVA may include, but are not limited to, a repeating unit derived from an N-vinyl monomer, an N-(meth)acryloyl monomer, or the like as described later, a repeating unit derived from ethylene, a repeating unit derived from alkyl vinyl ether, a repeating unit derived from a vinyl ester of monocarboxylic acid having a carbon atom number of 3 or more, and a repeating unit derived from a (di)acetone compound. One example of the N-vinyl monomer is N-vinylpyrrolidone. One example of the N-(meth)acryloyl monomer is N-(meth)acryloyl morpholine. The alkyl vinyl ether may be vinyl ether having an alkyl group having a carbon atom number of 1 or more and 10 or less, such as propylvinyl ether, butyl vinyl ether, or 2-ethylhexylvinyl ether. The vinyl ester of monocarboxylic acid having a carbon atom number of 3 or more may be a vinyl ester of monocarboxylic acid having a carbon atom number of 3 or more and 7 or less, such as vinyl propionate, vinyl butylate, vinyl pentanoate, and vinyl hexanoate. Examples of the (di)acetone compound include diacetone (meth)acrylamide and acetylacetone.

In some embodiments, an acetalized polyvinyl alcohol-based polymer is used as the polyvinyl alcohol-based polymer. Examples of the acetalized polyvinyl alcohol-based polymer include a modified PVA with partially acetalized VA units. The modified PVA with partially acetalized VA units (acetalized PVA (ac-PVA)) can be obtained by allowing the hydroxy groups in a polyvinyl alcohol-based polymer to partially react with an aldehyde compound or a ketone compound to undergo acetalization. Typically, an acetalized polyvinyl alcohol-based polymer can be obtained by acetalization between a polyvinyl alcohol-based polymer and an aldehyde compound. In some embodiments, the number of carbons in the aldehyde compound is 1 to 7, for instance, 2 to 7.

Examples of the aldehyde compound include formaldehyde; linear or branched alkyl aldehydes such as acetaldehyde, propionaldehyde, n-butylaldehyde, isobutylaldehyde, t-butylaldehyde, and hexylaldehyde; alicyclic or aromatic aldehydes such as cyclohexanecarbaldehyde and benzaldehyde. These can be used singly or in combination of two or more kinds thereof. In the aldehyde compound except for formaldehyde, one or more hydrogen atoms can be substituted with a halogen, etc. In particular, in view of high water solubility and facile acetalization, it can be a linear or branched alkyl aldehyde. Other possible examples include acetaldehyde, n-propylaldehyde, n-butylaldehyde, and n-pentylaldehyde.

Other possible aldehyde compounds besides the above include an aldehyde compound having 8 or more carbons, such as 2-ethylhexylaldehyde, nonyl aldehyde, or decyl aldehyde, may be used.

The acetalized polyvinyl alcohol-based polymer has a VA unit which is a structural segment represented by the next chemical formula -CH₂-CH(OH)- as well as an acetalized structural unit represented by the next general formula (1) (or "VAC unit" hereinafter).

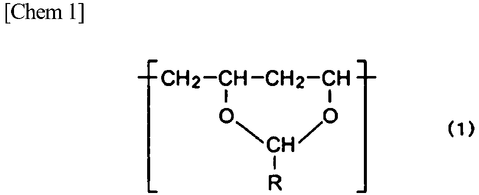

In the formula (1), R is a hydrogen atom, or a linear or branched alkyl group, with the alkyl group which may be substituted with a functional group.

In some embodiments, R in the formula (1) is a hydrogen atom or a linear or branched alkyl group with 1 to 6 carbons. R can be one kind or a combination of two or more kinds among these. In view of improving haze reduction, R can be a linear or branched alkyl chain with 1 to 6 carbons.

In view of improving haze reduction, the acetalized polyvinyl alcohol-based polymer can have a degree of acetalization of 1 mol% (% by mole) or higher, 5 mol% or higher, 10 mol% or higher, 15 mol% or higher, 20 mol% or higher, or 25 mol% or higher (e.g., 27 mol% or higher). In view of enhancing hydrophilicity, the acetalized polyvinyl alcohol-based polymer can have a degree of acetalization of below 60 mol%, 50 mol% or lower, 40 mol% or lower, 35 mol% or lower (e.g., 33 mol% or lower). As used herein, the degree of acetalization refers to the percentage of acetalized structural units (VAC units) relative to all repeating units forming the acetalized polyvinyl alcohol-based polymer.

As the polyvinyl alcohol-based polymer, a cationized polyvinyl alcohol in which a cationic group such as a quaternary ammonium structure has been introduced may be used. Example of the cationized polyvinyl alcohol include those having a cationic group derived from a cationic group-containing monomer such as a diallyl dialkyl ammonium salt and an N-(meth)acryloyl aminoalkyl-N,N,N-trialkyl ammonium salt. The vinyl alcohol-based polymer may have a non-VA unit having a structural segment represented by the chemical formula -CH₂-CH(CR¹ (OR⁴)-CR² (OR⁵)-R³)-. Here, R¹ to R³ are independently a hydrogen atom or an organic group, and R⁴ and R⁵ are independently a hydrogen atom or R⁶-CO- (wherein R⁶ is an alkyl group). For example, when at least one of R¹ to R³ in the chemical formula is an organic group, the organic group may be a liner or branched alkyl group with 1 to 8 carbons. R⁶ in the chemical formula may be a linear or branched alkyl group with 1 to 8 carbons.

In some embodiments, the modified PVA, a modified PVA can have a side chain 1,2-diol structure. For example, as the modified PVA, it is preferable to use a non-VAunit-containing modified PVA in which R¹ to R⁵ are hydrogen atoms (i.e., butenediol-vinyl alcohol copolymer (BVOH)).

The ratio of the number of moles of VA units to the number of moles of all repeating units constituting the polyvinyl alcohol-based polymer can be, for instance, 5 % or higher, 10 % or higher, 20 % or higher, or 30 % or higher. While no particular limitations are imposed, in some embodiments, the ratio of VA units by mole can be 50 % or higher, 65 % or higher, 75 % or higher, 80 % or higher, 90 % or higher (e.g., 95 % or higher, or 98 % or higher). VA units may account for essentially 100 % of repeating units forming the polyvinyl alcohol-based polymer. As used herein, "essentially 100 %" means that non-VA units are not included in the polyvinyl alcohol-based polymer, at least intentionally, and typically encompasses a case with less than 2 % non-VA units (e.g., less than 1 %) by mole in all repeating units, and a case with 0 % non-VA units. In other embodiments, the percentage of VA units by mole in all repeating units forming the polyvinyl alcohol-based polymer may can be, for instance, 95 % or lower, 90 % or lower, 80 % or lower, or 70 % or lower.

The amount (by weight) of VA units in the polyvinyl alcohol-based polymer can be, for instance, 5 wt% or greater, 10 wt% or greater, 20 wt% or greater, or 30 wt% or greater. While no particular limitations are imposed, in some embodiments, the VA unit content can be 50 wt% or greater (e.g., above 50 wt%), 70 wt% or greater, or 80 wt% or greater (e.g., 90 wt% or greater, or 95 wt% or greater, or 98 wt% or greater). VA units may account for essentially 100 wt% of repeating units forming the polyvinyl alcohol-based polymer. As used herein, "essentially 100 wt%" means that non-VA units are not included as a repeating unit forming the polyvinyl alcohol-based polymer, at least intentionally, and typically means that the non-VA unit content is less than 2 wt% (e.g., less than 1 wt%) of the polyvinyl alcohol-based polymer. In other embodiments, the VA unit content of the polyvinyl alcohol-based polymer can be, for instance, 95 wt% or less, 90 wt% or less, 80 wt% or less, or 70 wt% or less.

The polyvinyl alcohol-based polymer may include a plurality of polymer chains varying in VA unit content in the same molecule. As used herein, a polymer chain refers to a portion (segment) forming a part of one polymer molecule. For example, the polyvinyl alcohol-based polymer may include Polymer Chain A with VA unit content > 50 wt%, and Polymer Chain B with VA unit content < 50 wt% (i.e., with non-VA unit content > 50 wt%) in the same molecule.

Polymer Chain A may have only a VA unit as the repeating unit, or may include a non-VA unit in addition to the VA unit. The VA unit content of Polymer Chain A can be 60 wt% or greater, 70 wt% or greater, 80 wt% or greater, or 90 wt% or greater. In some embodiments, the VA unit content of Polymer Chain A can be 95 wt% or greater, or 98 wt% or greater. VA units may account for essentially 100 wt% of repeating units forming Polymer Chain A.

Polymer Chain B may have only a non-VA unit as the repeating unit, or may include a VA unit in addition to the non-VA unit. The non-VA unit content of Polymer Chain B can be 60 wt% or greater, 70 wt% or greater, 80 wt% or greater, or 90 wt% or greater. In some embodiments, the non-VA unit content of Polymer Chain B can be 95 wt% or greater, or 98 wt% or greater. Non-VA units may account for 100 wt% of repeating units forming Polymer Chain B.

Examples of the polyvinyl alcohol-based polymer with Polymer Chains A and B in the same molecule include a block copolymer and graft copolymer with these polymer chains. The graft copolymer may have a structure of Polymer Chain A (main chain) grafted with Polymer Chain B (side chain), or a structure of Polymer Chain B (main chain) grafted with Polymer Chain A (side chain). In some embodiments, a polyvinyl alcohol-based polymer having a structure of Polymer Chain A grafted with Polymer Chain B can be used.

Examples of Polymer Chain B include a polymer chain having a repeating unit derived from an N-vinyl monomer as a main repeating unit; a polymer chain having a repeating unit derived from an N-(meth)acryloyl monomer as a main repeating unit; a polymer chain having a repeating unit derived from vinyl dicarboxylate (vinyl ester of a dicarboxylic acid such as fumaric acid, maleic acid, maleic anhydride) as a main repeating unit; a polymer chain having a repeating unit derived from an aromatic vinyl monomer such as styrene and vinylnaphthalene as a main repeating unit; and a polymer chain having an oxyalkylene unit as a main repeating unit. In this description, the main repeating unit refers to a repeating unit accounting for more than 50 wt% unless otherwise stated.

A preferred example of Polymer Chain B is a polymer chain having an N-vinyl monomer as a main repeating unit, namely, an N-vinyl-based polymer chain. The amount of the N-vinyl monomer-derived repeating unit in the N-vinyl-based polymer chain is typically greater than 50 wt%, or may be 70 wt% or greater, 85 wt% or greater, or 95 wt% or greater. Essentially the entirety of Polymer Chain B may be formed of the N-vinyl monomer-derived repeating unit.

Examples of the N-vinyl monomer here include a monomer having a nitrogen-containing heterocycle (e.g., lactam ring), and N-vinyl linear amide. Specific examples of the N-vinyl lactam monomer include N-vinylpyrrolidone, N-vinylpiperidone, N-vinylmorpholinone, N-vinylcaprolactam, N-vinyl-1,3-oxazine-2-one, and N-vinyl-3,5-morpholinedione. Specific examples of the N-vinyl linear amide include N-vinyl acetoamide, N-vinyl propionamide, and N-vinyl butyramide. Polymer Chain B can be, for instance, an N-vinyl-based polymer chain in which N-vinylpyrrolidone units account for more than 50 wt% (e.g., 70 wt% or more, or 85 wt% or more, or 95 wt% or more) of the repeating units. Essentially all of the repeating units forming Polymer Chain B may be N-vinylpyrrolidone units.

Other examples of Polymer Chain B include a polymer chain having a repeating unit derived from an N-(meth)acryloyl monomer as a main repeating unit, namely, an N-(meth)acryloyl-based polymer chain. The amount of the N-(meth)acryloyl monomer-derived repeating unit in the N-(meth)acryloyl-based polymer chain is typically greater than 50 wt%, or may be 70 wt% or greater, 85 wt% or greater, or 95 wt% or greater. Essentially the entirety of Polymer Chain B may be formed of the N-(meth)acryloyl monomer-derived repeating unit.

Examples of the N-(meth)acryloyl monomer here include a linear amide having an N-(meth)acryloyl group, and a cyclic amide having an N-(meth)acryloyl group. Examples of the linear amide having an N-(meth)acryloyl group include (meth)acrylamide; N-alkyl (meth)acrylamides such as N-methyl (meth)acrylamide, N-ethyl (meth)acrylamide, N-propyl (meth)acrylamide, N-isopropyl (meth)acrylamide, and N-n-butyl (meth)acrylamide; and N,N-dialkyl (meth)acrylamide such as N,N-dimethyl (meth)acrylamide, N,N-diethyl (meth)acrylamide, N,N-dipropyl (meth)acrylamide, N,N-diisopropyl (meth)acrylamide, and N,N-di(n-butyl) (meth)acrylamide. Examples of the cyclic amide having an N-(meth)acryloyl group include N-(meth)acryloyl morpholine and N-(meth)acryloyl pyrrolidine.

Other examples of Polymer chain B include a polymer chain having an oxyalkylene unit as a main repeating unit, namely, an oxyalkylene-based polymer chain. The oxyalkylene unit content of the oxyalkylene-based polymer chain is typically greater than 50 wt%, or may be 70 wt% or greater, 85 wt% or greater, or 95 wt% or greater. Essentially all of the repeating units in Polymer Chain B may be oxyalkylene units.

Examples of the oxyalkylene unit include an oxyethylene unit, oxypropylene unit, and oxybutylene unit. These oxyalkylene units can be repeating units derived from the corresponding alkylene oxides. The oxyalkylene unit in the oxyalkylene-based polymer chain can be one kind, or two or more kinds. For example, the oxyalkylene-based polymer chain may include oxyethylene units and oxypropylene units in combination. In an oxyalkylene-based polymer chain with two or more kinds of oxyalkylene units, these oxyalkylene units can be each a random, block, alternate or graft copolymer of the corresponding alkylene oxide.

Yet other examples of Polymer Chain B include a polymer chain having a repeating unit derived from an alkyl vinyl ether (e.g., vinyl ether having an alkyl group with 1 to 10 carbon atoms), a polymer chain having a repeating unit derived from a monocarboxylic vinyl ester (e.g., vinyl ester of a monocarboxylic acid with 3 or more carbon atoms), and a polymer chain having a cationic group (e.g., a cationic group having a quaternary ammonium structure).

In some embodiments, the polyvinyl alcohol-based polymer as the second water-soluble polymer can be a modified polyvinyl alcohol that is a copolymer having a VA unit and a non-VA unit. The modified polyvinyl alcohol-based polymer as the second water-soluble polymer has a degree of saponification of typically 50 mol% or higher, preferably 65 mol% or higher, or more preferably 70 mol% or higher, for instance, 75 mol% or higher.

In other embodiments, polyvinyl alcohol-based polymers may not be used as the second water-soluble polymer. The art disclosed herein can be preferably implemented in an embodiment essentially free of a polyvinyl alcohol-based polymer as the second water-soluble polymer. For instance, the polyvinyl alcohol-based polymer content of the entire second water-soluble polymer can be 50 wt% or less (e.g., below 50 wt%), 30 wt% or less, 20 wt% or less, 10 wt% or less, or 5 wt% or less (e.g., 0 to 5 wt%).

In some preferable embodiments, an N-containing polymer is used as the second water-soluble polymer. The polishing composition including an N-containing polymer helps obtain a high-quality polished surface. The N-containing polymer typically includes an N-containing repeating unit (a repeating unit derived from a N-containing monomer). Non-limiting examples of the N-containing polymer include a polymer having an N-vinyl monomer unit and a polymer having an N-(meth)acryloyl monomer unit. As the N-containing polymer, solely one kind or a combination of two or more kinds can be used.

In some preferable embodiments, an N-vinyl polymer may be used as the second water-soluble polymer. Examples of the N-vinyl polymer include a polymer containing a repeating unit derived from a monomer having a nitrogen-containing heterocycle (e.g., lactam ring). Examples of such a polymer include homopolymers and copolymers of N-vinyllactam monomers (e.g., a copolymer having an N-vinyllactam monomer copolymerization ratio of above 50 wt%), and homopolymers and copolymers of N-vinyl linear amide (e.g., a copolymer having an N-vinyl linear amide copolymerization ratio of above 50 wt%).

Specific examples of the N-vinyllactam monomer (i.e., a compound having a lactam structure and a N-vinyl group in one molecule) include N-vinylpyrrolidone (VP), N-vinylpiperidone, N-vinylmorpholinone, N-vinylcaprolactam (VC), N-vinyl-1,3-oxazine-2-one, and N-vinyl-3,5-morpholinedione. Specific examples of N-vinyllactam monomer unit-containing polymers include polyvinyl pyrrolidone; polyvinyl caprolactam; a random copolymer of VP and VC; a random copolymer of one or both of VP and VC with another vinyl monomer (e.g., an acrylic monomer, a vinyl ester-based monomer, etc.); and a block, alternate or graft copolymer having a polymer chain with one or both of VP and VC.

Specific examples of the N-vinyl linear amide include N-vinylacetamide, N-vinylpropionamide, and N-vinylbutyramide.

In some preferable embodiments, an N-vinyl linear amide-based polymer is used as the second water-soluble polymer. Here, the N-vinyl linear amide-based polymer refers to a homopolymer or copolymer of an N-vinyl linear amide (e.g., N-vinylacetamide), for example, a copolymer having an N-vinyl linear amide copolymerization ratio of above 50 wt%. The use of an N-vinyl linear amide-based polymer as the second water-soluble monomer tends to result in good defect reduction. The amount of the N-vinyl linear amide-derived repeating unit in the N-vinyl linear amide-based polymer is typically greater than 50 wt%, or may be 70 wt% or greater, 85 wt% or greater, or 95 wt% or greater. Essentially the entirety of the N-vinyl linear amide-based polymer may be formed of the N-vinyl linear amide-derived repeating unit. A typical example of the N-vinyl linear amide-based polymer is poly-N-vinylacetamide (PNVA).

In some embodiments, N-(meth)acryloyl polymer can be used as the second water-soluble polymer. Examples of the N-(meth)acryloyl polymer include homopolymers and copolymers of N-(meth)acryloyl monomers (typically, a copolymer having an N-(meth)acryloyl monomer copolymerization ratio of above 50 wt%). Examples of the N-(meth)acryloyl monomers include linear amides having an N-(meth)acryloyl group and cyclic amides having an N-(meth)acryloyl group. With the inclusion of an N-(meth)acryloyl polymer (e.g., a polymer having an N-(meth)acryloyl group-containing cyclic amide as a monomer unit), the first water-soluble polymer may exhibit a greater effect (wettability improvement) while protecting the substrate surface. As used herein, the term (meth)acryloyl comprehensively refers to acryloyl and methacryloyl, and the term (meth)acryloyl group comprehensively refers to acryloyl and methacryloyl groups.

Examples of the linear amide having an N-(meth)acryloyl group include (meth)acrylamides; N-alkyl (meth)acrylamides such as N-methyl (meth)acrylamide, N-ethyl (meth)acrylamide, N-propyl (meth)acrylamide, N-isopropyl (meth)acrylamide, and N-n-butyl (meth)acrylamide; N,N-dialkyl (meth)acrylamides such as N,N-dimethyl (meth)acrylamide, N,N-diethyl (meth)acrylamide, N,N-dipropyl (meth)acrylamide, N,N-diisopropyl (meth)acrylamide, and N,N-di(n-butyl) (meth)acrylamide. Other examples thereof include N-hydroxyethylacrylamide (HEAA). Examples of a polymer containing the linear amide having an N-(meth)acryloyl group as a monomer unit include a homopolymer of N-isopropylacrylamide and a copolymer of N-isopropylacrylamide (e.g., a copolymer having an N-isopropylacrylamide copolymerization ratio of above 50 wt%). As used herein, (meth)acrylamide is intended to inclusively refer to acrylamide and methacrylamide.

Examples of the cyclic amide having an N-(meth)acryloyl group include N-acryloylmorpholine, N-acryloylthiomorpholine, N-acryloylpiperidine, N-acryloylpyrrolidine, N-methacryloylmorpholine, N-methacryloylpiperidine, and N-methacryloylpyrrolidine. Examples of a polymer containing the cyclic amide having an N-(meth)acryloyl group as a monomer unit include an acryloyl morpholine-based polymer (PACMO). Typical examples of the acryloyl morpholine-based polymer include a homopolymer of N-acryloylmorpholine (ACMO) and a copolymer of ACMO (e.g., a copolymer having an ACMO copolymerization ratio of above 50 wt%). In the acryloyl morpholine-based polymer, the percentage of ACMO by mole in all repeating units is typically 50 % or higher, or suitably 80 % or higher (e.g., 90 % or higher, typically 95 % or higher). Essentially all of the repeating units in the second water-soluble polymer can be formed of ACMO units.

In some embodiments, a carboxylic acid-based polymer is used as the second water-soluble polymer. Examples of the carboxylic acid-based polymer include maleic acid unit-containing polymers and (meth)acrylic acid unit-containing polymers. Examples of the maleic acid unit-containing polymers include styrene-maleic acid copolymer or salts thereof, styrene-maleic anhydride copolymer, styrenesulfonic acid-maleic acid copolymer or salts thereof, styrenesulfonic acid salt-maleic acid copolymer, and maleic acid-vinyl acetate copolymer. Examples of the (meth)acrylic acid unit-containing polymers include polyacrylic acid or salts thereof, styrene-acrylic acid copolymer or salts thereof, styrenesulfonic acid-acrylic acid copolymer or salts thereof, styrenesulfonic acid salt-acrylic acid copolymer, acrylic acid-vinyl acetate copolymer, and acrylic acid/sulfonic acid-based monomer copolymer. As used herein, the term (meth)acrylic acid comprehensively refers to acrylic acid and methacrylic acid.

In some embodiments, a random copolymer having VA and VP units can be used as the second water-soluble polymer. In this case, the random copolymer used as the second water-soluble polymer has a different chemical structure from the first water-soluble polymer. For instance, the copolymer may have a different molar ratio (VA/VP) or a different Mw from the first water-soluble polymer.

While no particular limitations are imposed, the art disclosed herein is preferably implemented in an embodiment that uses, as the second water-soluble polymer, one, two or more kinds selected from a cellulose derivative, a starch derivative, an oxyalkylene-unit-containing polymer, an N-containing polymer, or a carboxylic acid-based polymer. The second water-soluble polymer is selected preferably from a cellulose derivative, an oxyalkylene-unit-containing polymer or an N-containing polymer, or more preferably from a cellulose derivative or an N-containing polymer. For instance, in the embodiment that uses, as the second water-soluble polymer, one, two or more kinds selected from a cellulose derivative, a starch derivative, an oxyalkylene-unit-containing polymer, an N-containing polymer, or a carboxylic acid-based polymer, the amount of the selected one, two or more kinds (e.g., N-containing polymer) in the entire second water-soluble polymer can be 50 wt% or greater (e.g., above 50 wt%), 70 wt% or greater, 80 wt% or greater, 90 wt% or greater, or 95 wt% or greater (e.g., 95 wt% to 100 wt%).

The Mw of the second water-soluble polymer is not particularly limited. In some embodiments, in view of concentration efficiency, etc., the second water-soluble polymer can have a Mw of, for instance, about 200×10⁴ or lower, about 100×10⁴ or lower, 70×10⁴ or lower, 60×10⁴ or lower, 50×10⁴ or lower, 40×10⁴ or lower, or 30×10⁴ or lower. In view of improving the surface quality, in some embodiments, the Mw can be, for instance, 0.5×10⁴ or higher, 1×10⁴ or higher, 5×10⁴ or higher, or 8×10⁴ or higher (e.g., above 8×10⁴). In some preferable embodiments, the Mw is suitably 10×10⁴ or higher, or may be 15×10⁴ or higher, 20×10⁴ or higher, 25×10⁴ or higher, or 30×10⁴ or higher (e.g., above 30×10⁴). The use of the second water-soluble polymer with high Mw tends to help obtain high surface quality.

While no particular limitations are imposed, the art disclosed herein can be preferably implemented in an embodiment combining a first water-soluble polymer with relatively low Mw and a second water-soluble polymer with relatively high Mw. In some preferable embodiments, the ratio (Mw1/Mw2) of the first water-soluble polymer Mw (Mw1) to the second water-soluble polymer Mw (Mw2) is below 1, or may be 0.7 or lower, 0.5 or lower (e.g., below 0.5), 0.3 or lower, 0.2 or lower, or 0.1 or lower. In view of further increasing the wettability after polishing while favorably protecting the surface being polished, the ratio (Mw1/Mw2) is preferably 0.08 or lower, or may be 0.05 or lower (e.g., below 0.05, or 0.04 or lower). In some embodiments, the ratio (Mw1/Mw2) can be 0.001 or higher, 0.005 or higher, 0.008 or higher, 0.01 or higher, 0.05 or higher, or 0.07 or higher.

While no particular limitations are imposed, in some embodiments, the amount of the second water-soluble polymer in the polishing composition relative to 100 parts by weight of abrasive (typically silica particles) can be, for instance, 0.01 part by weight or greater. In view of defect reduction, etc., it is suitably 0.1 part by weight or greater, preferably 0.5 part by weight or greater, more preferably 1 part by weight or greater, yet more preferably 2 parts by weight or greater, or may be 2.5 parts by weight or greater, or 3 parts by weight or greater. The amount of the second water-soluble polymer per 100 parts by weight of abrasive can be, for instance, 50 parts by weight or less, or 30 parts by weight or less. In view of dispersion stability of the polishing composition, etc., in some embodiments, the amount of the second water-soluble polymer per 100 parts by weight of abrasive is suitably 15 parts by weight or less, preferably 10 parts by weight or less, and more preferably 5 parts by weight or less, or may be, for instance, 4.5 parts by weight or less, 4.0 parts by weight or less, or 3.5 parts by weight or less. By using the second water-soluble polymer in an amount suitably set within the above ranges, high surface quality can be obtained.

While no particular limitations are imposed, in some embodiments, the weight ratio (B/C) of the basic compound content (B) to the total water-soluble polymer content (total amount of water-soluble polymers: C) in the polishing composition can be, for instance, 0.01 or higher. In view of the polishing removal rate, etc., it is suitably 0.1 or higher, preferably 0.2 or higher, more preferably 0.5 or higher, or may be 0.7 or higher. In some embodiments, the weight ratio (B/C) can be, for instance, 15 or lower, or 10 or lower. In view of preferably protecting the surface being polished to maintain or improve the surface quality, the weight ratio (B/C) is suitably 7 or lower, preferably 5 or lower, and more preferably 2 or lower, or may be, for instance, 1.5 or lower. By suitably setting the total water-soluble polymer content and the basic compound content so that the ratio (B/C) falls within the above ranges, high surface quality can be obtained.

While no particular limitations are imposed, in some embodiments, the total water-soluble polymer content (total amount) in the polishing composition relative to 100 parts by weight of abrasive (typically silica particles) can be, for instance, 0.01 part by weight or greater. In view of improving the surface quality, etc., it is suitably 0.1 part by weight or greater, preferably 0.5 part by weight or greater, more preferably 1 part by weight or greater, even more preferably 2 parts by weight or greater, particularly preferably 3 parts by weight or greater, or may be 4 parts by weight or greater, or 5 parts by weight or greater. The total water-soluble polymer content in the polishing composition relative to 100 parts by weight of abrasive can be, for instance, 50 parts by weight or less, or 30 parts by weight or less. In view of dispersion stability of the polishing composition, etc., in some embodiments, the total water-soluble polymer content relative to 100 parts by weight of abrasive is suitably 15 parts by weight or less, preferably 12 parts by weight or less, or may be 10 parts by weight or less (e.g., less than 10 parts by weight).

While no particular limitations are imposed, in some embodiments, the weight ratio (W2/W1) of the second water-soluble polymer content W2 to the first water-soluble polymer content W1 is, for instance, 0.01 or higher, suitably 0.1 or higher, and preferably 0.2 or higher, or may be 0.4 or higher, 0.6 or higher, or 0.8 or higher. In some preferable embodiments, the ratio (W2/W1) can be 1.0 or higher, 1.2 or higher, or 1.4 or higher. In some embodiments, the maximum weight ratio (W2/W1) is, for instance, 30 or lower, suitably 20 or lower, or may be 10 or lower, 9 or lower, 8 or lower, 7 or lower, or 6 or lower. In some preferable embodiments, the ratio (W2/W1) is suitably 5 or lower, preferably 3 or lower, or may be 2 or lower (e.g., below 2). By suitably setting the ratio (W2/W1) within the above ranges, the effect of the art disclosed herein can be preferably obtained.

### <Surfactant (D)>

In some embodiments, the polishing composition preferably includes a surfactant. The surfactant in the polishing composition can further reduce defects and haze of the polished surface. According to the art disclosed herein, the combination of water-soluble polymers and the surfactant-containing composition can further improve the quality of the polished surface. The surfactant can be anionic, cationic, nonionic, or amphoteric. It is typically preferable to use an anionic or nonionic surfactant. In view of low foaming and ease of pH adjustment, a nonionic surfactant is more preferable. The use of nonionic surfactants tends to further improve defect reduction and haze reduction. Examples of the nonionic surfactant include oxyalkylene polymers such as polyethylene glycol, polypropylene glycol, and polytetramethylene glycol; polyoxyalkylene derivatives (e.g., polyoxyalkylene adducts) such as polyoxyethylene alkyl ether, polyoxyethylene alkyl phenyl ether, polyoxyethylene alkyl amine, polyoxyethylene fatty acid ester, polyoxyethylene glyceryl ether fatty acid ester, and polyoxyethylene sorbitan fatty acid ester; and copolymers of several kinds of oxyalkylene (e.g., diblock copolymers, triblock copolymers, random copolymers, and alternating copolymers). As the surfactant, solely one kind or a combination of two or more kinds can be used.

Specific examples of the nonionic surfactant include block copolymers of ethylene oxide (EO) and propylene oxide (PO) (diblock copolymers, PEO (polyethylene oxide)-PPO (polypropylene oxide)-PEO triblock copolymers, PPO-PEO-PPO triblock copolymers, etc.), random copolymers of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene-2-ethylhexylether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octyl phenyl ether, polyoxyethylene nonyl phenyl ether, polyoxyethylene dodecyl phenyl ether, polyoxyethylene styrated phenyl ether, polyoxyethylene laurylamine, polyoxyethylene stearylamine, polyoxyethylene oleylamine, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, and polyoxyethylene castor wax. Particularly preferable surfactants include block copolymers of EO and PO (in particular, PEO-PPO-PEO triblock copolymer), random copolymers of EO and PO, and polyoxyethylene alkyl ethers (e.g., polyoxyethylene decyl ether). A preferable polyoxyethylene alkyl ether has about 1 mole to 10 (e.g., about 3 to 8) moles of EO added.

The surfactant has a molecular weight of, for instance, below 5000, preferably below 3000. The use of a surfactant with a molecular weight below 3000 tends to result in a polishing composition that is effective in defect reduction. In some preferable embodiments, the surfactant has a molecular weight of, for instance, below 2000, more preferably 1900 or lower (e.g., below 1800), yet more preferably 1500 or lower, or may be 1000 or lower (e.g., 500 or lower). In view of surfactant activity, the molecular weight of the surfactant is typically suitably 200 or higher. In view of haze reduction, it is preferably 250 or higher (e.g., 300 or higher).

Preferable molecular weight ranges of the surfactant may also vary depending on the kind of surfactant. For instance, when using a polyoxyethylene alkyl ether as the surfactant, its molecular weight is, for instance, preferably below 2000, more preferably 1900 or lower (e.g., below 1800), yet more preferably 1500 or lower, or may be 1000 or lower (e.g., 500 or lower). For instance, when a block copolymer of EO and PO is used as the surfactant, it can have a weight-average molecular weight of, for instance, 500 or higher, 1000 or higher, 1500 or higher, 2000 or higher, or even 2500 or higher. The maximum weight average molecular weight is, for instance, below 5000, preferably 4500 or lower, for instance, or may be below 4000, or below 3500.

The molecular weight of the surfactant can be calculated from its chemical formula, or the weight average molecular weight determined by GPC (aqueous phase, based on standard polyethylene glycols) can be used. For instance, in case of a polyoxyethylene alkyl ether, the molecular weight calculated from its chemical formula is preferably used. In case of an EO/PO block copolymer, the weight average molecular weight determined by GPC is preferably used.

While no particular limitations are imposed, in an embodiment where the polishing composition includes a surfactant, in view of ease of cleaning, etc., the surfactant content per 100 parts by weight of abrasive (typically, silica particles) is suitably 20 parts by weight or less, preferably 10 parts by weight or less, more preferably 5 parts by weight or less, yet more preferably 3 parts by weight or less, particularly preferably 1 part by weight or less (e.g., below 1 part by weight), or may be 0.8 part by weight or less. In view of getting more effective use of the surfactant, the surfactant content per 100 parts by weight of abrasive is suitably 0.001 part by weight or greater, preferably 0.01 part by weight or greater, and more preferably 0.1 part by weight or greater, or may be 0.3 part by weight or greater.

While no particular limitations are imposed, in an embodiment where the polishing composition includes a surfactant, the weight ratio (D/C) of the surfactant content (D) to the total water-soluble polymer content (C) can be, for instance, 0.001 or higher. In view of defect reduction, etc., it is suitably 0.005 or higher, preferably 0.01 or higher, more preferably 0.03 or higher, or may be 0.05 or higher. In some embodiments, the weight ratio (D/C) can be, for instance, 10 or lower. In view of defect reduction, etc., it is suitably 1 or lower (e.g., below 1), preferably 0.5 or lower, more preferably 0.3 or lower, or may be, for instance, 0.15 or lower, or 0.10 or lower.

### <Water>

Preferable examples of the water in the polishing composition disclosed herein include ion-exchanged water (deionized water), pure water, ultrapure water, and distilled water. To maximally avoid inhibition of the activities of other components in the polishing composition, for instance, the total amount of transition metal ions in the water used is preferably 100 ppb or less. For example, the water purity can be increased by removal of impurity ions with ion-exchange resin, removal of contaminants with filters, distillation, etc. The polishing composition disclosed herein may further include an organic solvent that can mix uniformly with water (lower alcohol, lower ketone, etc.), as needed. The solvent in the polishing composition is preferably at least 90 vol% (% by volume) water, or more preferably at least 95 vol% water (e.g., 99 vol% to 100 vol%).

### <Other Components>

As long as the effect of this invention is not significantly impaired, the polishing composition disclosed herein may further include, as necessary, known additives that can be used in polishing compositions (e.g., polishing compositions used in final polishing steps of silicon wafers), such as organic acids, organic acid salts, inorganic acids, inorganic acid salts, chelating agents, antiseptic agents, and antifungal agents.

Among organic and inorganic acids and salts thereof, solely one kind or a combination of two or more kinds can be used. Examples of organic acids include aliphatic acids such as formic acid, acetic acid, and propionic acid; aromatic carboxylic acids such as benzoic acid and phthalic acid; itaconic acid; citric acid; oxalic acid; tartaric acid; malic acid; maleic acid; fumaric acid; succinic acid; glycolic acid; malonic acid; gluconic acid; alanine; glycine; lactic acid; hydroxyethylidene diphosphoric acid (HEDP); organic sulfonic acid such as methanesulfonic acid; nitrilotris(methylenephosphoric acid) (NTMP); and organic phosphonic acid such as phosphonobutane tricarboxylic acid (PBTC). Examples of organic acid salts include alkali metal salts (sodium salts, potassium salts, lithium salts, etc.) and ammonium salts of organic acids. Examples of inorganic acids include hydrochloric acid, phosphoric acid, sulfuric acid, phosphonic acid, nitric acid, phosphinic acid, boric acid, and carbonic acid. Examples of inorganic acid salts include alkali metal salts (sodium salts, potassium salts, lithium salts, etc.) of inorganic acids.

As the chelating agent, solely one kind or a combination of two or more kinds can be used. Examples of the chelating agent include aminocarboxylic acid-based chelating agents and organic phosphonic acid-based chelating agents. Favorable examples of chelating agents include ethylenediamine tetrakis(methylenephosphinic acid), diethylene triamine penta(methylenephosphinic acid), and diethylene triamine pentaacetic acid. Examples of the antiseptic agent and antifungal agent include isothiazoline-based compounds, paraoxybenzoic acid esters, and phenoxyethanol.

The polishing composition disclosed herein is preferably essentially free of an oxidant. This is because when an oxidant-containing polishing composition is supplied to a substrate (e.g., a silicon wafer), it may oxidize the substrate surface and form an oxide layer, thereby reducing the polishing removal rate. Specific examples of the oxidant here include hydrogen peroxide (H₂O₂), sodium persulfate, ammonium persulfate, and sodium dichroloisocyanurate. The polishing composition being essentially free of an oxidant refers to at least no intentional inclusion of an oxidant. Thus, the concept of essentially oxidant-free polishing composition here can include a polishing composition that inevitably includes a trace amount of oxidant (e.g., a molar concentration of an oxidant in polishing composition being 0.001 mol/L or less, preferably 0.0005 mol/L or less, more preferably 0.0001 mol/L or less, yet more preferably 0.00005 mol/L or less, particularly preferably 0.00001 mol/L or less) due to the starting materials, manufacturing process, etc.

### <pH>

The pH of the polishing composition disclosed herein is not particularly limited, and a suitable pH can be selected according to the substrate, etc. In some embodiments, the polishing composition has a pH of suitably 8.0 or higher, preferably 8.5 or higher, more preferably 9.0 or higher. With increasing pH of the polishing composition, the polishing removal rate tends to increase. Meanwhile, in view of preventing dissolution of silica particles and suppressing deterioration of mechanical polishing action, the polishing composition typically has a pH of suitably 12.0 or lower, preferably 11.0 or lower, more preferably 10.8 or lower, or even more preferably 10.5 or lower.

In the art disclosed herein, the pH of a polishing compound can be determined by using a pH meter (e.g., a glass-electrode pH meter (model F-72) available from Horiba, Ltd.). More specifically, in the method used, after three-point calibration using standard buffer solutions (phthalate pH buffer with pH 4.01 (25 °C), neutral phosphate pH buffer with pH 6.86 (25 °C), and carbonate pH buffer with pH 10.01 (25 °C)), the glass electrode is placed in the polishing composition to be measured for at least two minutes; after the pH of the polishing composition has stabilized, the pH is measured.

### <Polishing Slurry>

The polishing composition disclosed herein is typically supplied to the substrate surface as a polishing slurry that includes the polishing composition, and used for polishing the substrate. For instance, the polishing slurry can be prepared by diluting a polishing composition disclosed herein (typically, with water). Alternatively, the polishing composition may be used as is as the polishing slurry. Other examples of the polishing slurry that includes the polishing composition disclosed herein include a polishing slurry obtained by adjusting the pH of the composition.

The amount of abrasive (typically silica particles) in the polishing slurry is not particularly limited. It is, for instance, 0.005 wt% or greater, preferably 0.01 wt% or greater, more preferably 0.03 wt% or greater, yet more preferably 0.05 wt% or greater, or may be 0.08 wt% or greater, or 0.10 wt% or greater (e.g., above 0.10 wt%). With increasing abrasive content, a higher polishing removal rate can be obtained. The abrasive content is suitably 10 wt% or less, preferably 7 wt% or less, more preferably 5 wt% or less, or even more preferably 2 wt% or less, for instance, 1 wt% or less, or may be 0.5 wt% or less, 0.4 wt% or less, or 0.3 wt% or less. This helps maintain surface quality.

The amount of basic compound in the polishing slurry is not particularly limited. In view of increasing the polishing removal rate, etc., in typical, it is suitably 0.0005 wt% or greater, preferably 0.001 wt% or greater, more preferably 0.003 wt% or greater, or yet more preferably 0.005 wt% or greater (e.g., above 0.005 wt%). In view of improving the surface quality (e.g., haze reduction), etc., it is suitably below 0.1 wt%, preferably below 0.05 wt%, or more preferably below 0.03 wt% (e.g., below 0.025 wt%, or even below 0.01 wt%).

While no particular limitations are imposed, in some embodiments, in view of increasing the wettability, etc., the first water-soluble polymer content W1 (particularly, a random copolymer including VA and VP units) of the polishing slurry may be, for instance, 0.0001 wt% or greater. Typically it is suitable to be 0.0005 wt% or greater, preferably 0.001 wt% or greater, or may be, for instance, 0.002 wt% or greater, or 0.0025 wt% or greater. The maximum first water-soluble polymer content W1 is not particularly limited. For instance, it can be, 0.05 wt% or less. In view of the stability in a concentrated form, polishing removal rate, cleanability, etc., in some embodiments, the first water-soluble polymer content W1 is preferably 0.03 wt% or less, more preferably 0.015 wt% or less, and even more preferably 0.01 wt% or less. The polishing slurry disclosed herein can be implemented, for instance, in an embodiment where the first water-soluble polymer content W1 is 0.008 wt% or less, 0.006 wt% or less, or 0.004 wt% or less.

While no particular limitations are imposed, in some embodiments, in view of defect reduction, etc., the second water-soluble polymer content W2 of the polishing slurry may be, for instance, 0.0001 wt% or greater. Typically it is suitable to be 0.0005 wt% or greater, preferably 0.001 wt% or greater, or may be 0.002 wt% or greater, 0.003 wt% or greater, or 0.004 wt% or greater. The maximum second water-soluble polymer content W2 is not particularly limited. It can be, for instance, 0.1 wt% or less. In view of the stability, polishing removal rate, cleanability in a concentrated form, etc., in some embodiments, the second water-soluble polymer content W2 is preferably 0.05 wt% or less, more preferably 0.02 wt% or less, even more preferably 0.01 wt% or less (e.g., below 0.01 wt%), or may be 0.007 wt% or less, or 0.005 wt% or less.

The total water-soluble polymer content (total amount of water-soluble polymers) in the polishing slurry is not particularly limited. In some embodiments, it can be, for instance, 0.0001 wt% or greater. In view of improving surface quality, etc., the total amount is preferably 0.0005 wt% or greater, more preferably 0.001 wt% or greater, even more preferably 0.002 wt% or greater, or may be, for instance, 0.005 wt% or greater. In some embodiments, the maximum total amount is, for instance, 0.5 wt% or less. In view of the polishing removal rate, etc., it is preferably 0.2 wt% or less, more preferably 0.1 wt% or less, even more preferably 0.05 wt% or less, particularly preferably 0.02 wt% or less, or may be 0.01 wt% or less (e.g., below 0.01 wt%).

When the polishing slurry includes a surfactant, the amount of surfactant in the polishing slurry (when two or more kinds of surfactant are included, their total amount) is not particularly limited. Typically, in view of cleanability, the surfactant content can be, for instance, 0.00001 wt% or greater. In view of defect reduction, haze reduction, etc., it is preferably 0.0001 wt% or greater, more preferably 0.0003 wt% or greater, or yet more preferably 0.0005 wt% or greater. In view of the polishing removal rate, etc., in some embodiments, it is preferably 0.1 wt% or less, more preferably 0.01 wt% or less, yet more preferably 0.005 wt% or less, or particularly preferably 0.001 wt% or less (e.g., below 0.001 wt%).

### <Concentrated liquid>

The polishing composition disclosed herein may be in a concentrated form (i.e., in the form of a polishing slurry concentrated liquid) before supplied to a substrate. Such concentrated polishing compositions are preferred in view of convenience and cost reduction during production, distribution, storage, etc. The concentration factor is not particularly limited. For instance, it can be about 2-fold to 100-fold in volume, and is usually suitably about 5-fold to 50-fold (e.g., about 10-fold to 40-fold). Such a concentrated liquid can be diluted when desired to prepare a polishing slurry (working slurry), which can then be used by supplying it to a substrate. The dilution can be performed by adding water to the concentrated liquid and mixing them, for instance.

When the polishing composition (i.e., the concentrated liquid) is diluted for use in polishing, the abrasive content of the concentrated liquid can be, for instance, 25 wt% or less. In view of dispersion stability and filterability of the polishing composition, the abrasive content is typically preferably 20 wt% or less, or more preferably 15 wt% or less. In some preferred embodiments, the abrasive content may be 10 wt% or less, or 5 wt% or less. In view of convenience and cost reduction during production, distribution, storage, etc., the abrasive content of the concentrated liquid can be, for instance, 0.1 wt% or greater, and is preferably 0.5 wt% or greater, more preferably 0.7 wt% or greater, or even more preferably 1 wt% or greater (e.g., above 1 wt%).

In some embodiments, the amount of basic compound in the concentrated liquid can be, for instance, less than 15 wt%. In view of storage stability, etc., the basic compound content is typically preferably 10 wt% or less (e.g., below 10 wt%), more preferably 3 wt% or less, or may be 1 wt% or less (e.g., below 1 wt%), or 0.5 wt% or less. In view of convenience and cost reduction during production, distribution, storage, etc., the amount of basic compound in the concentrated liquid can also be, for instance, 0.005 wt% or greater, preferably 0.01 wt% or greater, more preferably 0.05 wt% or greater, or yet more preferably 0.1 wt% or greater.

In some embodiments, the combined amount (total amount) of water-soluble polymers in the concentrated liquid can be, for instance, 3 wt% or less. In view of the filterability and ease of cleaning of the polishing composition, it is typically preferably 1 wt% or less, or more preferably 0.5 wt% or less. In view of convenience and cost reduction during production, distribution, storage, etc., it is typically suitably 0.001 wt% or greater, preferably 0.005 wt% or greater, more preferably 0.01 wt% or greater, or yet more preferably 0.1 wt% or greater.

In an embodiment where the polishing composition includes a surfactant, the surfactant content of the concentrated liquid can be, for instance, 0.25 wt% or less, preferably 0.15 wt% or less, more preferably 0.1 wt% or less, or may be 0.05 wt% or less, or 0.025 wt% or less. The surfactant content of the concentrated liquid can also be, for instance, 0.0001 wt% or greater, preferably 0.001 wt% or greater, more preferably 0.005 wt% or greater, or even more preferably 0.01 wt% or greater.

### <Preparation of Polishing Composition>

The polishing composition used in the art disclosed herein may be a single-agent type or a multi-agent type such as a two-agent type. For instance, the polishing composition may be configured to prepare a polishing slurry by mixing Part A and Part B and diluting the mixture as needed when appropriate, with Part A including at least the abrasive among its components and Part B including at least some of the remaining components.

The method for preparing the polishing composition is not particularly limited. For instance, the respective components of the polishing composition can be mixed, using a known mixing device such as a blade stirrer, ultrasonic disperser, or homomixer. The embodiment of mixing these components is not particularly limited. For instance, all the components may be mixed at once or in a predetermined suitable order.

### <Applications>

The polishing composition disclosed herein is suitable for polishing a surface formed of a silicon material (typically, for polishing a silicon wafer). Specific examples of the silicon material include single silicon crystal, amorphous silicon, and polysilicon. The polishing composition disclosed herein can be particularly preferably used for polishing a surface formed of single silicon crystal (e.g., for polishing a silicon wafer).

The polishing composition disclosed herein can be preferably applied to a step of polishing a substrate (e.g., a silicon wafer). Before the polishing step with the polishing composition disclosed herein, the substrate may be subjected to a general treatment applicable to the substrate in a step upstream of the polishing step, such as lapping or etching.

The polishing composition disclosed herein is effective when used in the final polishing step of a substrate (e.g., a silicon wafer) or in the polishing step immediately preceding it. It is particularly preferable for use in the final polishing step. The final polishing step here refers to the last polishing step (i.e., the step followed by no further polishing) in a manufacturing process of objects of interest. The polishing composition disclosed herein may also be used in a polishing step upstream of the final polishing (the upstream step referring to a stock polishing step between the rough polishing step and the last polishing step, typically including at least a primary polishing step, or may further include a secondary, tertiary, etc. polishing steps). For instance, it can be used in a polishing step performed immediately before final polishing.

The polishing composition disclosed herein is effectively used, for instance, in polishing (typically, final polishing or polishing just before that) a silicon wafer adjusted to a surface roughness of 0.01 nm to 100 nm in an upstream step. It is particularly preferable for final polishing. The surface roughness Ra of a substrate can be measured using, for instance, laser scanning surface roughness meter TMS-3000WRC available from Schmitt Measurement System Inc.

### <Polishing>

The polishing composition disclosed herein can be used for polishing a substrate, for instance, in an embodiment including the following operation. Described next is a preferable embodiment of the method for polishing a silicon wafer as the substrate, using the polishing composition disclosed herein.

In other words, a polishing slurry is obtained, including a polishing composition disclosed herein. Obtaining the polishing slurry may include preparing the polishing slurry by subjecting the polishing composition to concentration adjustment (e.g., dilution), pH adjustment, etc. Alternatively, the polishing composition may be used as is as a polishing slurry.

Subsequently, the polishing slurry is supplied to a substrate, and polishing is carried out by a common method. For example, in final polishing of a silicon wafer, the silicon wafer that has undergone a lapping step is typically set in a general polishing machine, and then the polishing slurry is supplied through the polishing pad of the polishing machine to the silicon wafer surface to be polished. Typically, while the polishing slurry is continuously supplied, the polishing pad is pushed against the silicon wafer surface to be polished and both are moved (rotated) relative to each other. Through such a polishing step, the substrate is completely polished.

The polishing pad used in the polishing step is not particularly limited. The polishing pad can be of, for instance, foamed polyurethane, nonwoven fabric, suede, etc. Each polishing pad may or may not include an abrasive. Usually, abrasive-free polishing pads are preferably used.

The substrate polished with the polishing composition disclosed herein is typically cleaned. Cleaning can be performed using a suitable cleaning solution. The cleaning solution used is not particularly limited. For instance, it is possible to use SC-1 cleaning solution (a mixture of ammonium hydroxide (NH₄OH), hydrogen peroxide (H₂O₂) and water (H₂O)), SC-2 cleaning solution (a mixture of HCl, H₂O₂, and H₂O), ozone water cleaning solution, hydrofluoric acid cleaning solution, etc., which are common in the semiconductor industry. The temperature of the cleaning solution can be within the range of room temperature (typically, about 15 °C to 25 °C) or higher to about 90 °C. In view of improving the cleaning effect, a cleaning solution at about 50 °C to 85 °C can be preferably used.

As mentioned above, the art disclosed herein may also provide a method for producing a polished material, the method including a polishing step (preferably the final polishing) by an aforementioned polishing method (e.g., a method for producing a silicon wafer); and a polished material (e.g., a silicon wafer) produced by the method.

The matters disclosed herein include the following:
(1) A polishing composition used in polishing a surface formed of a silicon material, the polishing composition including
   an abrasive (A), a basic compound (B), a first water-soluble polymer (C1), and a second water-soluble polymer (C2) that has a different chemical structure from the first water-soluble polymer (C1), wherein
   the first water-soluble polymer (C1) is a random copolymer having a vinyl alcohol unit and an N-vinylpyrrolidone unit.
(2) The polishing composition according to (1) above, wherein the second water-soluble polymer (C2) is at least one kind selected from the group consisting of a cellulose derivative, a starch derivative, an oxyalkylene-unit-containing polymer, a polyvinyl alcohol-based polymer, a nitrogen-atom-containing polymer and a carboxylic acid-based polymer.
(3) The polishing composition according to (1) or (2) above, wherein the weight ratio of the second water-soluble polymer (C2) content to the first water-soluble polymer (C1) content is 0.1 or higher and 20 or lower.
(4) The polishing composition according to any of (1) to (3) above, wherein the first water-soluble polymer (C1) has a weight-average molecular weight (Mw) of 2×10⁴ or lower.
(5) The polishing composition according to any of (1) to (4) above, wherein the abrasive (A) contains silica particles.
(6) The polishing composition according to any of (1) to (5) above, further including a surfactant (D).
(7) A concentrated liquid of the polishing composition according to any of (1) to (6) above.
(8) A polishing method including a step of polishing a surface formed of a silicon material, using the polishing composition according to any of (1) to (7) above.

### [Examples]

Several examples relating to the present invention will be described below, but the present invention is not to be limited to the embodiments shown in the examples. In the following description, "part" and "%" are by weight unless otherwise specified.

### <Preparation of Polishing Composition>

### (Example 1)

Were mixed an abrasive, a basic compound, water-soluble polymers, a surfactant, and deionized water to prepare a polishing composition concentrated liquid according to this example. As the abrasive, was used colloidal silica with an average primary particle diameter of 25 nm. As the basic compound, ammonia was used. As the water-soluble polymers, were used a random copolymer having a vinyl alcohol unit and an N-vinylpyrrolidone unit with Mw of about 3.0×10⁴ (poly(VA-r-VP), first water-soluble polymer) and polyacryloylmorpholine with Mw of about 35×10⁴ (PACMO, second water-soluble polymer). As the surfactant, was used polyoxyethylene decyl ether (C10EO5) with 5 moles of ethylene oxide added. The resulting polishing composition concentrated liquid was diluted 40-fold by volume with deionized water to obtain a polishing composition (0.13 % abrasive, 0.01 % basic compound, 0.003 % poly(VA-r-VP), 0.004 % PACMO and 0.001 % C10EO5) according to this example.

### (Example 2)

As the second water-soluble polymer, was used a poly-N-vinylacetamide (PNVA) with Mw of about 27×10⁴. Otherwise in the same manner as in Example 1, was prepared a polishing composition according to this example.

### (Example 3)

As the first water-soluble polymer, was used a random copolymer (poly(VA-r-VP) with Mw of about 1.4×10⁴. Otherwise in the same manner as in Example 1, was prepared a polishing composition according to this example.

### (Example 4)

As the first water-soluble polymer, was used a random copolymer (poly(VA-r-VP) with Mw of about 3000. Otherwise in the same manner as in Example 1, was prepared a polishing composition according to this example.

### (Comparative Example 1)

As the first water-soluble polymer, was used an acetalized polyvinyl alcohol (ac-PVA) with Mw of about 1.0×10⁴. Otherwise in the same manner as in Example 1, was prepared a polishing composition according to this example.

### (Comparative Example 2)

As the first water-soluble polymer, was used a graft copolymer (PVA-g-PVP) having a vinyl alcohol unit and an N-vinylpyrrolidone unit with Mw of about 17.5×10⁴. Otherwise in the same manner as in Example 1, was prepared a polishing composition according to this example.

### (Comparative Example 3)

As the water-soluble polymer, was used only poly (VA-r-VP). No second water-soluble polymer was used. Otherwise in the same manner as in Example 1, was prepared a polishing composition according to this example.

### <Silicon Wafer Polishing>

Under Polishing condition 1, was stock-polished a lapped and etched commercially available silicon single crystal wafer (P-type conductivity, <100> crystal orientation, free of COP (crystal originated particles, i.e., crystal defects)) with a diameter of 300 mm to obtain a silicon wafer as the substrate. The stock polishing was performed using a polishing slurry with 0.6 % abrasive (colloidal silica with an average primary particle diameter of 35 nm) and 0.08 % tetramethylammonium hydroxide (TMAH) in deionized water.

### [Polishing Condition 1]

Polishing machine: a single wafer polishing machine, model PNX-332B, manufactured by Okamoto Machine Tool Works, Ltd.
Polishing pressure: 20 kPa
Platen rotational speed: 20 rpm
Head (carrier) rotational speed: 20 rpm
Polishing pad: product name SUBA400 manufactured by Nitta Dupont Inc.
Supply flow rate of polishing slurry: 1.0 L/min
Polishing slurry temperature: 20 °C
Platen cooling water temperature: 20 °C
Polishing time: 2 min

Using the polishing composition prepared above according to each example as the polishing slurry, the silicon wafer after stock polishing was polished under Polishing condition 2 and consecutively under Polishing condition 3 shown below.

### [Polishing Condition 2]

Polishing machine: a single wafer polishing machine, model PNX-332B, manufactured by Okamoto Machine Tool Works, Ltd.
Polishing pressure: 16 kPa
Platen rotational speed: 52 rpm
Head (carrier) rotational speed: 50 rpm
Polishing pad: product name POLYPAS275NX manufactured by Fujibo Ehime Co., Ltd.
Supply flow rate of polishing slurry: 1.5 L/min
Polishing slurry temperature: 20 °C
Platen cooling water temperature: 20 °C
Polishing time: 2 min

### [Polishing Condition 3]

Polishing machine: a single wafer polishing machine, model PNX-332B, manufactured by Okamoto Machine Tool Works, Ltd.
Polishing pressure: 20 kPa
Platen rotational speed: 52 rpm
Head (carrier) rotational speed: 50 rpm
Polishing pad: product name POLYPAS275NX manufactured by Fujibo Ehime Co., Ltd.
Supply flow rate of polishing slurry: 1.5 L/min
Polishing slurry temperature: 20 °C
Platen cooling water temperature: 20 °C
Polishing time: 2 min

### <Measurement of Water-Repellent Distance>

When unloading the polished silicon wafer, was measured the maximum radial distance (water-repellent distance) of the water-repellent area from the wafer edges. The measurement values (mm) were converted into relative values with the measurement value (mm) in Comparative Example 1 being 100 %. The resulting values are shown in the corresponding column in Table 1. The smaller the water-repellent distance (%), the better the wettability is evaluated.

### <Cleaning>

The polished silicon wafer was removed from the polishing machine and subjected to a total of 15 sets of cleaning processes, with one set consisting of cleaning with an ozone water cleaning solution (60 seconds) using a single wafer cleaning machine followed by cleaning with SC-1 cleaning solution using a brush (110 seconds) followed by cleaning with an ozone water cleaning solution (20 seconds) and cleaning with a hydrofluoric acid cleaning solution (15 seconds); and it was further cleaned with an ozone water cleaning solution (20 seconds), and then dried.

### <LPD Analysis>

Using a wafer surface tester (product name SURFSCAN SP5 available from KLA-Tencor Corporation), the number of LPD present on the cleaned silicon wafer surface was analyzed in the Oblique mode of the device. The results were converted into relative values with the number of LPD in Comparative Example 1 being 100 %. The resulting values are shown in the corresponding column in Table 1.

### [Table 1]

**Table 1**

| | 1st water-soluble polymer | | | 2nd water-soluble polymer | | | Water-repellent distance (%) | LPD (%) |
|---|---|---|---|---|---|---|---|---|
| | Polymer | Mw | Concentration (%) | Polymer | Mw | Concentration (%) | | |
| Ex. 1 | poly(VA-r-VP) | 30,000 | 0.003 | PACMO | 350,000 | 0.004 | 2 | 79 |
| Ex. 2 | poly(VA-r-VP) | 30,000 | 0.003 | PNVA | 270,000 | 0.004 | 20 | 43 |
| Ex. 3 | poly(VA-r-VP) | 14,000 | 0.003 | PACMO | 350,000 | 0.004 | 0 | 29 |
| Ex. 4 | poly(VA-r-VP) | 3,000 | 0.003 | PACMO | 350,000 | 0.004 | 0 | 63 |
| Comp.Ex. 1 | Ac-PVA | 10,000 | 0.003 | PACMO | 350,000 | 0.004 | 100 | 100 |
| Comp.Ex. 2 | PVA-g-PVP | 175,000 | 0.003 | PACMO | 350,000 | 0.004 | 194 | 80 |
| Comp.Ex. 3 | poly(VA-r-VP) | 30,000 | 0.003 | - | - | - | 4 | 113 |

As shown in Table 1, among the polishing compositions including an abrasive, a basic compound and two kinds of water-soluble polymers, with respect to Examples 1 to 4 using a random copolymer having a VA unit and a VP unit as a water-soluble polymer, the water-repellent distance greatly decreased and LPD was also reduced as compared with Comparative Example not using the random copolymer having the VA unit and the VP unit as a water-soluble polymer. With respect to Comparative Example 2 using a PVA-PVP graft copolymer as one of the two kinds of water-soluble polymers, while LDP was reduced, there was a tendency for water-repellent distance to increase, leading to inferior wettability. As for Comparative Example 3 using only poly(VA-r-VP) as the water-soluble polymer, the water-repellent distance was small, but LPD was not reduced.

Although specific embodiments of the present invention have been described in detail above, these are merely for illustrations and do not limit the scope of claims. The art according to the claims includes various modifications and changes made to the specific embodiments illustrated above.

## Claims

1. A polishing composition used in polishing a surface formed of a silicon material, the polishing composition containing
an abrasive (A), a basic compound (B), a first water-soluble polymer (C1), and a second water-soluble polymer (C2) that has a different chemical structure from the first water-soluble polymer (C1), wherein
the first water-soluble polymer (C1) is a random copolymer having a vinyl alcohol unit and an N-vinylpyrrolidone unit.

2. The polishing composition according to Claim 1, wherein the second water-soluble polymer (C2) is at least one kind selected from the group consisting of a cellulose derivative, a starch derivative, an oxyalkylene-unit-containing polymer, a polyvinyl alcohol-based polymer, a nitrogen-atom-containing polymer and a carboxylic acid-based polymer.

3. The polishing composition according to Claim 1 or 2, wherein the weight ratio of the second water-soluble polymer (C2) content to the first water-soluble polymer (C1) content is 0.1 or higher and 20 or lower.

4. The polishing composition according to Claim 1 or 2, wherein the first water-soluble polymer (C1) has a weight-average molecular weight of 2×10⁴ or lower.

5. The polishing composition according to Claim 1 or 2, wherein the abrasive (A) comprises silica particles.

6. The polishing composition according to Claim 1 or 2, further comprising a surfactant (D).

7. A concentrated liquid of the polishing composition according to Claim 1 or 2.

8. A polishing method comprising a step of polishing a surface formed of a silicon material, using the polishing composition according to Claim 1 or 2.
